# EUROPEAN PATENT APPLICATION

(11) **EP 4 694 575 A1**
(43) Date of publication of application: **11.02.2026**
(21) Application number: 24777496.1
(22) Date of filing: 31.01.2024
(51) Int. Cl.: H05B 3/06, H05K 7/20, H01S 3/04, G02B 6/42

(54) **LASER HEATING MODULE, CENTRALIZED UNIFORM HEAT DISSIPATION DEVICE, LASER HEATING DEVICE AND CIRCUIT DRIVE BOX**

(30) Priority: 27.03.2023 CN 202320636597 U; 01.06.2023 CN 202321384956 U; 26.06.2023 CN 202321637938 U; 11.09.2023 CN 202322469039 U
(71) Applicant: XIAO, Yan, Shenzhen, Guangdong 518101 (HK)
(72) Inventor: XIAO, Yan, Shenzhen, Guangdong 518101 (CN); LIU, Mengxiong, Shenzhen, Guangdong 518101 (CN); WANG, Yong, Shenzhen, Guangdong 518101 (CN); LU, Shengdong, Shenzhen, Guangdong 518101 (CN)
(74) Representative: Chung, Hoi Kan
(86) International application number: PCT/CN2024/074921
(87) International publication number: WO 2024/198702

(57) **Abstract**

A high-power laser heating module, comprising: a heat dissipation block (1) on which thermally conductive bosses (14) are formed; a drive circuit board (11), which is arranged on the heat dissipation block (1); a flexible printed circuit board (12), which is attached to the heat dissipation block (1) and is provided with embedding grooves (122), wherein bending sections (121) extending from the heat dissipation block (1) are arranged on two sides of the flexible printed circuit board and are configured to be electrically connected to the drive circuit board (11); and a plurality of laser tool members (2), which are arranged on the thermally conductive bosses (14) of the heat dissipation block (1) and the flexible printed circuit board (12) in an array, wherein the laser tool members (2) are internally provided with laser chips (6); the laser chips (6) of the laser tool members (2) are electrically connected to the flexible printed circuit board (12); and the thermally conductive bosses (14) are embedded in the embedding grooves (122) of the flexible printed circuit board (12), so that the laser tool members (2) are thermally coupled and connected to the heat dissipation block (1) by means of skipping over the flexible printed circuit board (12).

## Description

### CROSS-REFERENCE TO RELATED APPLICATIONS

The present disclosure claims priority to Chinese Patent Application No.2023206365973 filed on March 27, 2023, and entitled "HIGH-POWER LASER HEATING MODULE AND IRRADIATION HEATING EQUIPMENT FOR SURFACE HEATING", Chinese Patent Application No. 2023213849567, filed on June 1, 2023, and entitled " A CENTRALIZED UNIFORM HEAT DISSIPATION DEVICE FOR HIGH-POWER MULTI-MODULE CHIPS", Chinese Patent Application No. 2023216379385 FILED ON June 26, 2023, and entitled "LASER HEATING DEVICE", Chinese Patent Application No. 2023224690395 filed on September 11, 2023, and entitled "A CIRCUIT DRIVE BOX AND LASER MODULE", the contents of which are herein incorporated by reference in their entireties.

### TECHNICAL FIELD

The present disclosure relates to the field of laser application technologies, and in particular, relates to a laser heating module, a centralized uniform heat dissipation device, a laser heating device, and a circuit drive box.

### BACKGROUND

With the development of laser devices such as semiconductor lasers and vertical-cavity surface-emitting lasers, high-power laser heating scenarios have become increasingly common. However, issues including high power consumption, difficult heat dissipation, and large volume have restricted product development. Therefore, the industry is in urgent need of integrated and simplified product solutions that address all these factors.

### SUMMARY

A high-power laser heating module, including:
a heat sink block, wherein a cooling water channel is arranged in the heat sink block, and a plurality of heat-conducting bosses are integrally formed on a top surface of the heat sink block;
a drive circuit board, arranged on a bottom surface of the heat sink block;
a flexible circuit board, attached to the heat sink block, wherein the flexible circuit board is provided with embedded slots for the heat-conducting bosses to pass through, and both sides of the flexible circuit board are provided with bent sections extending from the heat sink block, the bent sections being bent to the bottom surface of the heat sink block for electrical connection with the drive circuit board; and
a plurality of laser fixtures, arranged in an array on the heat-conducting bosses of the heat sink block and the flexible circuit board, wherein a laser chip is arranged in each of the plurality of laser fixtures, and the laser chip of each of the plurality of laser fixtures is electrically connected to the flexible circuit board, and each of the heat-conducting bosses is embedded in one of the embedded slots of the flexible circuit board, so that the laser fixtures are thermally coupled to the heat sink block in a manner of bypassing the flexible circuit board.

An irradiation heating device for surface heating, including at least one group of module units, wherein each group of module units comprises a fixed beam and a plurality of high-power laser heating modules as described above, wherein the plurality of high-power laser heating modules are arranged along a length direction of the fixed beam, mounting blocks are fixedly arranged at the bottom of the heat sink block, the mounting blocks are arranged at both ends of the heat sink block along a length direction of the bent section, the mounting blocks being fixedly connected to the fixed beam.

A centralized uniform heat dissipation device, including a water supply mechanism, a water outlet mechanism, and at least one multi-waterway macro-channel mechanism; wherein
each of the multi-waterway macro-channel mechanisms comprises a base plate and a plurality of multi-waterway macro-channel modules and has an accommodating cavity, wherein the base plate is provided with multiple pairs of first water inlets and first water outlets, and each pair of first water inlets and first water outlets is respectively in communication with the accommodating cavity, a water channel being arranged in the accommodating cavity to allow water to flow in from a first water inlet and then flow out from a first water outlet; and the plurality of multi-waterway macro-channel modules are symmetrically disposed on the base plate; and base plates of a plurality of multi-waterway macro-channel mechanisms face the same direction and are abutted side by side; and
the water supply mechanism and the water outlet mechanism are respectively in communication with first water inlets and first water outlets of the plurality of multi-waterway macro-channel modules, and are configured to supply water to the multi-waterway macro-channel modules and discharge water from the multi-waterway macro-channel modules.

The centralized uniform heat dissipation device for high-power multi-module chips according to claim 1, wherein the first water inlets and first water outlets on the base plate are disposed on both sides of the accommodating cavity.

A laser heating device, including:
a housing, provided with an accommodating cavity, and an opening and a gas-filling port respectively communicating with the accommodating cavity;
a laser assembly, arranged in the accommodating cavity, wherein the laser assembly comprises an irradiation member arranged corresponding to the opening, the irradiation member being capable of emitting light through the opening; and
a heat dissipation unit, arranged in the accommodating cavity for dissipating heat from the irradiation member;
wherein the gas-filling port is configured to be connected to a gas-filling device.

A circuit drive box, including a base, herein a component device is arranged in the base, an outer wall of the base is provided with a plug-in part electrically connected to an external power supply, the component device is electrically connected to the plug-in part; and the base is filled with a thermal grease, the thermal grease encapsulating the component device to conduct heat from the component device to the base.

A laser module, including the aforementioned circuit drive box and a plurality of chip lamp beads, wherein a plurality of the circuit drive boxes arranged side by side on a plate surface of a water-cooled board and electrically connected to an external power supply, the plurality of the chip lamp beads arranged side by side on a side of the water-cooled board facing away from the circuit drive box, and in one-to-one correspondence with positions of the plurality of circuit drive boxes and electrically connected to the plurality of circuit drive boxes.

### BRIEF DESCRIPTION OF DRAWINGS

To describe the technical solutions in the embodiments of the present disclosure more clearly, the following briefly describes the accompanying drawings required for describing the embodiments. Apparently, the accompanying drawings in the following description show merely some embodiments of the present disclosure, and those of ordinary skill in the art may still derive other drawings from these accompanying drawings without creative efforts.
FIG. 1 is a schematic diagram showing an overall structure of a heating module according to some embodiments.
FIG. 2 is a schematic structural diagram showing a laser fixture according to some embodiments.
FIG. 3 is a schematic diagram showing structures of a heat sink block and a flexible circuit board according to some embodiments.
FIG. 4 is an enlarged view of Part A in FIG. 3.
FIG. 5 is a cross-sectional view of a heat sink block according to some embodiments.
FIG. 6 is a schematic structural diagram showing a housing according to some embodiments.
FIG. 7 is an exploded view of a housing according to some embodiments.
FIG. 8 is a cross-sectional view mainly showing a housing according to some embodiments.
FIG. 9 is a schematic structural diagram of a centralized uniform heat dissipation device according to some embodiments.
FIG. 10 is a schematic structural diagram of a multi-path macro-channel mechanism according to some embodiments.
FIG. 11 is a schematic structural diagram of a base plate of a multi-path macro-channel mechanism according to some embodiments.
FIG. 12 is a schematic structural diagram of a top plate of a multi-path macro-channel mechanism according to some embodiments.
FIG. 13 is a schematic structural diagram of a water supply mechanism according to some embodiments.
FIG. 14 is a schematic structural diagram of a water supply mechanism from another angle according to some embodiments.
FIG. 15 is a cross-sectional view of a water supply mechanism according to some embodiments.
FIG. 16 is a schematic structural diagram of a water outlet mechanism according to some embodiments.
FIG. 17 is a cross-sectional view of a water outlet mechanism according to some embodiments.
FIG. 18 is a schematic structural diagram of a water outlet connection block according to some embodiments.
FIG. 19 is a schematic structural diagram of a laser heating device according to some embodiments.
FIG. 20 is a schematic structural diagram of another view of the laser heating device in FIG. 19.
FIG. 21 is a schematic diagram of an internal structure of the laser heating device in FIG. 19.
FIG. 22 is an assembly diagram of a heat dissipation component and a laser component in the laser heating device of FIG. 19.
FIG. 23 is a schematic structural diagram of a laser component in the laser heating device of FIG. 19.
FIG. 24 is a schematic structural diagram of a control component in the laser heating device of FIG. 19.
FIG. 25 is a schematic structural diagram of a laser module according to some embodiments.
FIG. 26 is a schematic structural diagram of a laser module according to some embodiments.
FIG. 27 is a schematic structural diagram of a laser module according to some embodiments.
FIG. 28 is a schematic structural diagram of a circuit drive box according to some embodiments.
FIG. 29 is a cross-sectional view of a circuit drive box according to some embodiments.

### DETAILED DESCRIPTION OF THE EMBODIMENTS

The technical solutions in the embodiments of the present disclosure will now be described in detail with reference to the accompanying drawings. It should be understood that the embodiments described herein are only a portion of the embodiments of the present disclosure, rather than all the embodiments. All other embodiments obtained by those skilled in the art based on the embodiments of the present disclosure, without making creative labor, shall fall within the protection scope of the present disclosure.

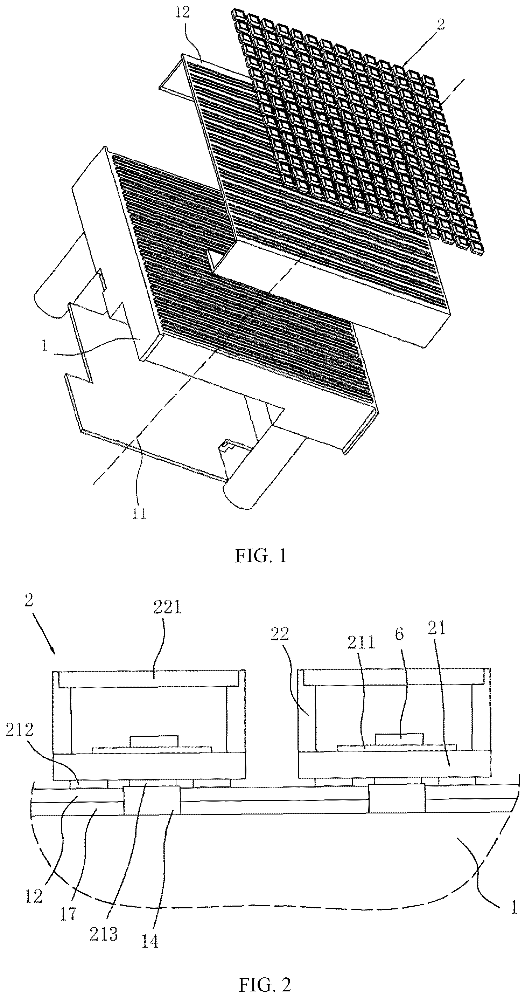

Referring to FIG. 1, a high-power laser heating module includes a heat sink block 1. A plurality of laser fixtures 2 are arranged in an array on the heat sink block 1. The heat sink block 1 is made of a metal material with high thermal conductivity, the thickness of the heat sink block 1 is 15 mm. In the embodiments, the heat sink block 1 is made of copper. To facilitate arbitrary assembly, the heat sink block 1 is configured as a square structure, that is, the surface of the heat sink block 1 on which the laser fixture 2 is mounted is square. The laser fixtures 2 are arranged in an equidistant array on the heat sink block 1, and the area of the heat sink block 1 is consistent with the light-emitting surface.

Referring to FIG. 1, a drive circuit board 11 is provided on the side wall of the heat sink block 1 facing away from the laser fixtures 2. The drive circuit board 11 is fixed on the bottom wall of the heat sink block 1 via screws, where the bottom wall of the heat sink block 1 refers to the side wall facing away from the laser fixtures 2. The drive circuit board 11 is connected to an external power supply via wires.

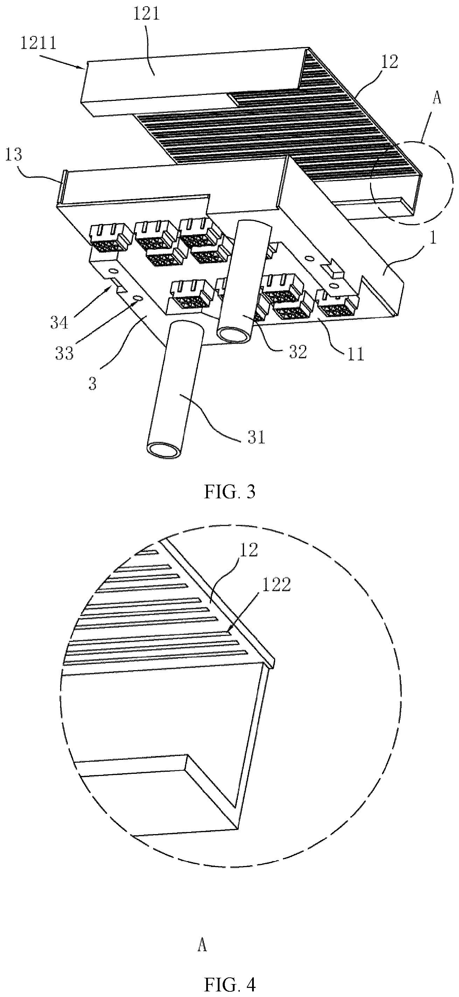

Referring to FIG. 1 and FIG. 3, a flexible circuit board 12 is arranged between the heat sink block 1 and the laser fixtures 2. Both ends of the flexible circuit board 12 are connected to bent sections 121 designed to conform to the side walls of the heat sink block 1. The bent sections 121 are electrically connected to the drive circuit board 11. Both ends of the bent section 121 are provided with positioning notches 1211, and the heat sink block 1 is fixedly provided with positioning ridges 13 for snap-fitting with the positioning notches. Both sides of the bent sections 121 abut against the positioning ridges 13, serving to position the bent sections 121, prevent the bent sections 121 from loosening or misaligning, and thus prevent displacement of the entire flexible circuit board 12.

Referring to FIG. 2, a laser chip 6 is provided in the laser fixture 2, the flexible circuit board 12 is electrically connected to the laser chip 6, the flexible circuit board 12 is a flexible printed circuit board, and an insulating layer 17 is provided between the flexible circuit board 12 and the heat sink block 1. The laser fixture 2 includes a substrate 21 and a housing 22. A transmission layer 211 is fixedly provided on the substrate 21, and the laser chip 6 is fixedly provided on the transmission layer 211. The substrate 21 is made of aluminum nitride with good thermal conductivity, a low thermal expansion coefficient, and serves as an electrical insulator with good dielectric properties. The housing 22 is fixedly provided on the substrate 21, a glass plate 221 is provided on the top of the housing 22 to facilitate laser transmission. The bottom wall of the substrate 21 is fixedly provided with a first contact pad 212 and a second contact pad 213, the first contact pad 212 and the second contact pad 213 are made of copper, the number of the first contact pads 212 is two, and two of the first contact pads 212 are disposed on both sides of the second contact pad 213. The first contact pad 212 is electrically connected to the flexible circuit board 12, and the laser chip 6 is electrically connected to the first contact pad 212 through the transmission layer 211. The laser chip 6 is connected to the flexible circuit board 12 through the first contact pad 212, and the laser chip 6 is disposed in the laser package to achieve thermoelectric separation of the laser chip 6 and to improve the heat dissipation effect of the laser chip 6.

Referring to FIG. 2, the top wall of the heat sink block 1 integrally forms heat-conducting bosses 14. The top wall of the heat sink block 1 is adjacent to the side wall of the laser fixture 2. A plurality of heat-conducting bosses 14 are arranged in parallel intervals, and the length of the heat-conducting boss 14 is less than the width of the heat sink block 1, ensuring a certain distance between both ends of the heat-conducting boss 14 and the side wall of the heat sink block 1. The substrate 21 is fixedly provided on the heat-conducting bosses 14. The heat-conducting bosses 14 are welded to the second contact pads 213. The second contact pads 213 are provided on the bottom surface of the substrate 21 to facilitate welding the substrate 21 to the heat-conducting bosses 14.

Referring to FIGS. 2 and 4, the heat-conducting bosses 14 are arranged along the length direction parallel to the bent section 121, and the flexible circuit board 12 is provided with embedded slots 122 for the heat-conducting bosses 14 to pass through. The heat-conducting bosses 14 are embedded in both sides of the embedded slots 122 of the flexible circuit board 12, so as to enable the laser fixture 2 to thermally couple to the heat sink block 1 by bypassing the flexible circuit board 12, thereby improving the heat dissipation efficiency. The heat-conducting bosses 14 are snap-fit into the embedded slots 122, and the length and width of the heat-conducting boss 14 match the embedded slot 122 to limit the flexible circuit board 12, effectively preventing the flexible circuit board 12 from shifting; and the heat-conducting bosses 14 pass directly through the flexible circuit board 12, enabling the heat from the laser chip 6 to be quickly transferred through the heat-conducting bosses 14 to the heat sink block 1, thereby effectively improving the heat dissipation effect.

Referring to FIG. 2, the heat-conducting bosses 14 are flush with or above the surface of the flexible circuit board 12. The heat-conducting bosses 14 are provided on the heat sink block 1 and protrude above the surface of the flexible circuit board 12 to prevent interference with the flexible circuit board 12, such that the laser fixture 2 is mounted on the heat-conducting boss 14 flatly, ensuring that both the laser fixture 2 and the laser chip 6 on the entire heat sink block 1 remain level. Furthermore, a gap exists between the laser fixture 2 and the flexible circuit board 12, allowing heat from the laser chip 6 to be directly transferred to the heat-conducting boss 14 for efficient heat dissipation.

Referring to FIG. 3, mounting blocks 3 are fixedly arranged at the bottom of the heat sink block, the mounting blocks 3. Both ends of the heat sink block 1 are arranged along the length direction of the bent section 121. The mounting block 3 is provided with threaded holes 33, and the mounting block 3 is provided with locking grooves 34.

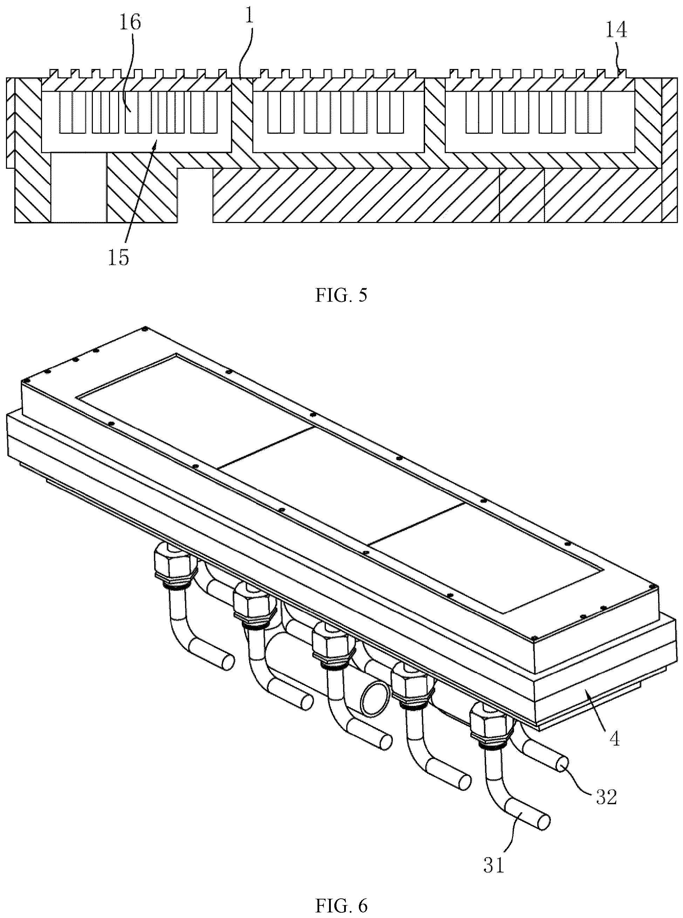

Referring to FIG. 5, a cooling water channel 15 is arranged in the heat sink block 1. An inlet pipe 31 and an outlet pipe 32 are provided on the heat sink block 1, and the inlet pipe 31 and the outlet pipe 32 are in communication with the cooling water channel 15. The inlet pipe 31 and the outlet pipe 32 are respectively disposed at opposite ends along the diagonal of the heat sink block 1. A heat dissipation structure of fin-pin 16 is arranged in the cooling water channel 15. The heat dissipation structure of the fin-pin 16 includes a plurality of vertically arranged fin-pins 16 made of copper. The cross-section of each fin-pin 16 is either rhombic or rectangular. One end of each fin-pin 16 is fixedly connected to the top wall of the heat sink block 1, and the other end is inserted into the cooling water channel 15 and comes into contact with the cooling water.

The heat generated by the laser chip 6 is transferred to the heat-conducting bosses 14, and then transmitted to the cooling water in the cooling water channel 15 through the heat dissipation structure of the fin-pin 16. This structure increases the contact area with the cooling water. In addition, the heat dissipation structure of the fin-pin 16 arranged in the cooling water channel 15 extends the contact time between the cooling water and the heat sink block 1, thereby improving the heat dissipation effect.

The implementation principle of the embodiments of the present disclosure is as follows: Each heating module includes a plurality of laser chips 6 encapsulated in the laser fixture 2 and distributed at equal intervals on the heat sink block 1 with a square structure. The drive circuit board 11 is arranged at the bottom of the heat sink block 1, and the flexible circuit board 12 is disposed between the laser fixture 2 and the heat sink block 1. This structure facilitates the assembly of the laser fixture 2, ensuring a seamless connection without any step-like sensation.

Meanwhile, the bent section 121 of the flexible circuit board 12 is connected to the drive circuit board 11 at the bottom of the heat sink block 1. This design reduces the space occupied by the flexible circuit board 12. The drive circuit board 11 is arranged at the bottom of the heat sink block 1, which reduces the floor space of the entire module and makes the module more compact. Meanwhile, the circuit structures, such as the plurality of laser chips 6, the flexible circuit board 12, and the drive circuit board 11 are arranged on the same heat sink block 1. In addition, the area of the heat sink block 1 is the same as that of the light-emitting surface, which facilitates the free splicing of the plurality of laser heating modules with each other.

The heat generated during the operation of the laser chip 6 is directly conducted to the copper heat sink block 1 through the copper heat-conducting bosses 14, and then the heat is carried away by the cooling water. This structure avoids the presence of multi-layer media such as circuit structures between the laser chip 6 and the heat sink block 1, thereby improving the heat dissipation effect.

The embodiments of the present disclosure disclose an irradiation heating device for surface heating.

Referring to FIGS. 1 and 2, the irradiation heating device for surface heating includes at least one group of module units, and a laser device can be composed of one group of module units or a plurality of sets of module units arranged side by side. Each group of module units includes a housing 4, a fixed beam 5, and a plurality of laser heating modules. The number of laser heating modules in each group of module units can be adjusted arbitrarily according to actual needs, and there are five laser heating modules in this embodiment.

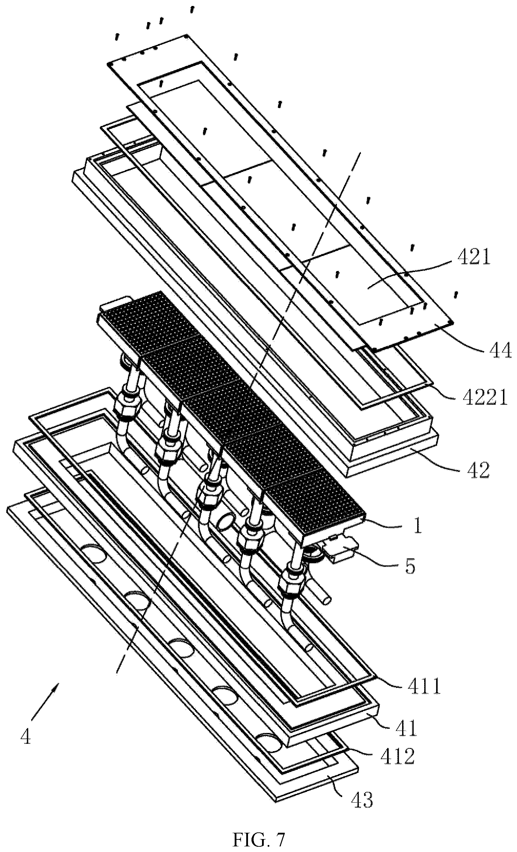

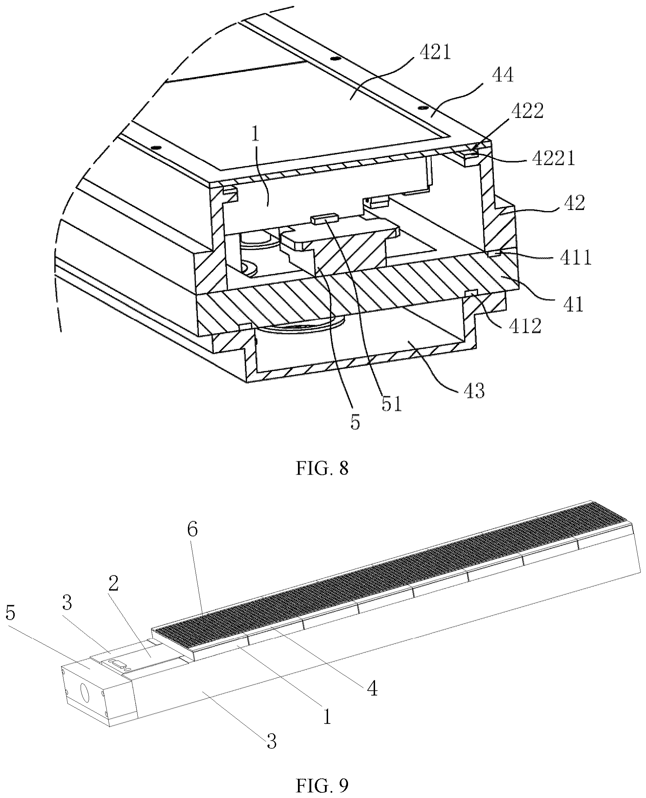

Referring to FIGS. 7 and 8, the plurality of high-power laser heating modules are arranged along the length direction of the fixed beam 5. The fixed beam 5 is fixedly connected to the mounting block 3 via screws. The fixed beam 5 is disposed in the middle of the heat sink block 1and disposed between the inlet pipe 31 and the outlet pipe 32, so as to avoid interference. In addition, a locking block 51 for inserting into the locking groove 34 is fixedly arranged on the fixed beam 5. During installation, the locking block 51 is inserted into the locking groove 34 of the mounting block 3, which plays a role in positioning the fixed beam 5 and the heat sink block 1, thereby facilitating secure installation.

Referring to FIGS. 7 and 8, the housing 4 includes a base plate 41, an upper cover plate 42, and a lower cover plate 43. The upper cover plate 42 and the lower cover plate 43 are fixedly arranged on the base plate 41. The housing 4 has a cavity, and the laser heating module is disposed in the cavity. The upper cover plate 42 is formed with an opening, which is provided with window plates 421. A plurality of window plates 421 are arranged along the length direction of the upper cover plate 42. The laser package is opposite to the window plates 421, such that the emitted laser can exit through the window plates 421. A pressure ring 44 is fixedly arranged on the top wall of the upper cover plate 42. The top wall of the upper cover plate 42 refers to the side wall facing away from the lower cover plate 43. The pressure ring 44 is fixed on the top wall of the upper cover plate 42 via fixing screws.

Specifically, referring to FIGS. 7 and 8, the side wall of the upper cover plate 42 is provided with a clamping groove 422 along the length direction of the upper cover plate 42. A first sealing ring 4221 is disposed on the side wall of the clamping groove 422 away from the pressure ring 44, and the first sealing ring 4221 is made of rubber. The side wall of the window plate 421 is clamped in the clamping groove 422, and the pressure ring 44 presses the window plate 421 tightly against the first sealing ring 4221, achieving sealing and cushioning effects.

Referring to FIGS. 7 and 8, a second sealing ring 411 is arranged between the upper cover plate 42 and the top wall of the base plate 41, and a third sealing ring 412 is arranged between the lower cover plate 43 and the bottom wall of the base plate 41. Both the second sealing ring 411 and the third sealing ring 412 are made of rubber. Specifically, embedding grooves are formed on both the top wall and the bottom wall of the base plate 41, the second sealing ring 411 is embedded in the embedding groove on the top wall of the base plate 41, and the third sealing ring 412 is embedded in the embedding groove on the bottom wall of the base plate 41.

Referring to FIGS. 9, 10, and 11, the present disclosure provides a centralized uniform heat dissipation device for high-power multi-module chips, which includes a water supply mechanism 2, two water outlet mechanisms 3, a chip 6, and eight multi-waterway macro-channel mechanisms 1.

A single multi-waterway macro-channel mechanism 1 includes a base plate 105 and four multi-waterway macro-channel modules. A single multi-waterway macro-channel module has an accommodating cavity 101. The base plate 105 is provided with eight pairs of first water inlets 102 and first water outlets 103, and each multi-waterway macro-channel module is correspondingly provided with two pairs of first water inlets 102 and first water outlets 103. Each pair of the first water inlet 102 and the first water outlet 103 is respectively in communication with the accommodating cavity 101, and a water channel is provided in the accommodating cavity 101, such that water flows in from the first water inlet 102 and then flows out from the first water outlet 103. It should be noted that multi-waterway macro-channels are arranged in the accommodating cavity 101, among which the waterways are densely distributed in the accommodating cavity 101, enabling water to fully absorb the heat, thereby achieving efficient heat dissipation. The four multi-waterway macro-channel modules are symmetrically distributed on the base plate 105, and the base plates 105 of the eight multi-waterway macro-channel mechanisms 1 face the same direction and are butted side by side. The symmetrical arrangement of the multi-waterway macro-channel modules and the side-by-side connection of the multi-waterway macro-channel mechanisms 1 can make full use of space. As the heat dissipation surfaces face the same direction, the chips 6 are placed on the multi-waterway macro-channel mechanisms 1, enabling extensive and uniform heat dissipation.

The aforementioned water supply mechanism 2 and water outlet mechanism 3 are respectively connected to the first water inlets 102 and first water outlets 103 of the thirty-two multi-waterway macro-channel modules in the eight multi-waterway macro-channel mechanisms 1, and are used to supply water to the multi-waterway macro-channel modules and discharge water from the multi-waterway macro-channel modules.

In the device provided by the present disclosure, eight multi-waterway macro-channel mechanisms 1 are arranged side by side. Each multi-waterway macro-channel mechanism 1 dissipates heat for the chips 6 attached above it. The multi-waterway macro-channel modules in each multi-waterway macro-channel mechanism 1 store water through the accommodating cavity 101 and allow water to flow therein, thereby achieving a heat dissipation effect. The side-by-side arrangement of the multi-waterway macro-channel mechanisms 1 has the advantages of a small volume and a large area. During the process of water flowing through the accommodating cavity 101, the heat is absorbed and then discharged along with the water. The water circulates through the accommodating cavity 101 and is then discharged, realizing continuous heat dissipation. Moreover, in the present disclosure, the water supply mechanism 2 supplies water to the multi-waterway macro-channel modules, and the water is then discharged from the water outlet mechanism 3. The water supply mechanism 2 supplies water to each multi-waterway macro-channel mechanism 1, ensuring uniform heat dissipation. In addition, four multi-waterway macro-channel modules are arranged in the multi-waterway macro-channel mechanism 1, which reduces the size of each accommodating cavity 101. This design allows the water in the accommodating cavities 101 to be replaced quickly, achieving a good heat dissipation effect.

To achieve a better heat dissipation effect, the first water inlets 102 and first water outlets 103 arranged on the base plate 105 are disposed at both sides of the accommodating cavity 101. The first water inlets 102 and the first water outlets 103 are disposed on both sides of the accommodating cavity 101, which maximizes the flow path of water inside the accommodating cavity 101 and achieves the optimal heat dissipation effect. The first water inlets 102 are disposed in the middle of the base plate 105, the first water outlets 103 are disposed on both sides of the base plate 105, and corresponding multi-waterway macro-channel modules are distributed side by side on the base plate 105. The first water inlets 102 and first water outlets 103 on both sides of the accommodating cavity 101 of the multi-waterway macro-channel modules are correspondingly disposed on both sides of the base plate 105.

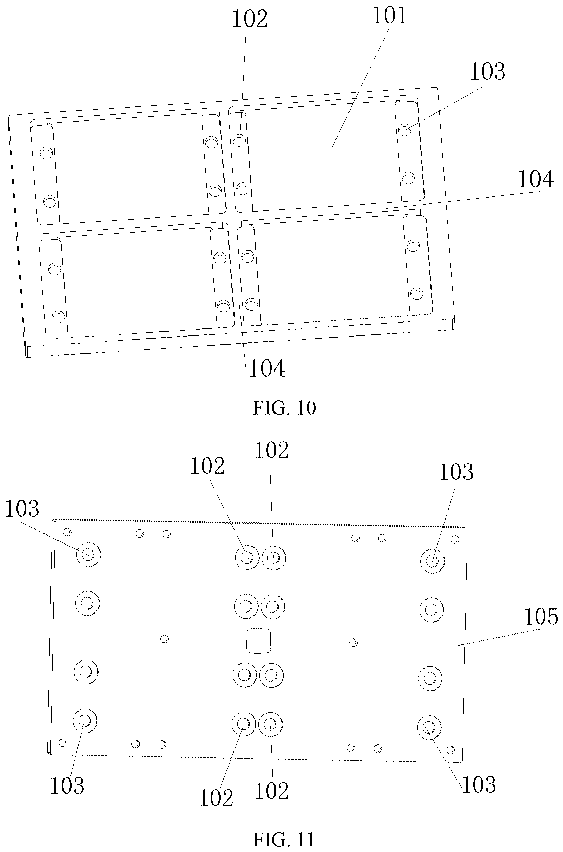

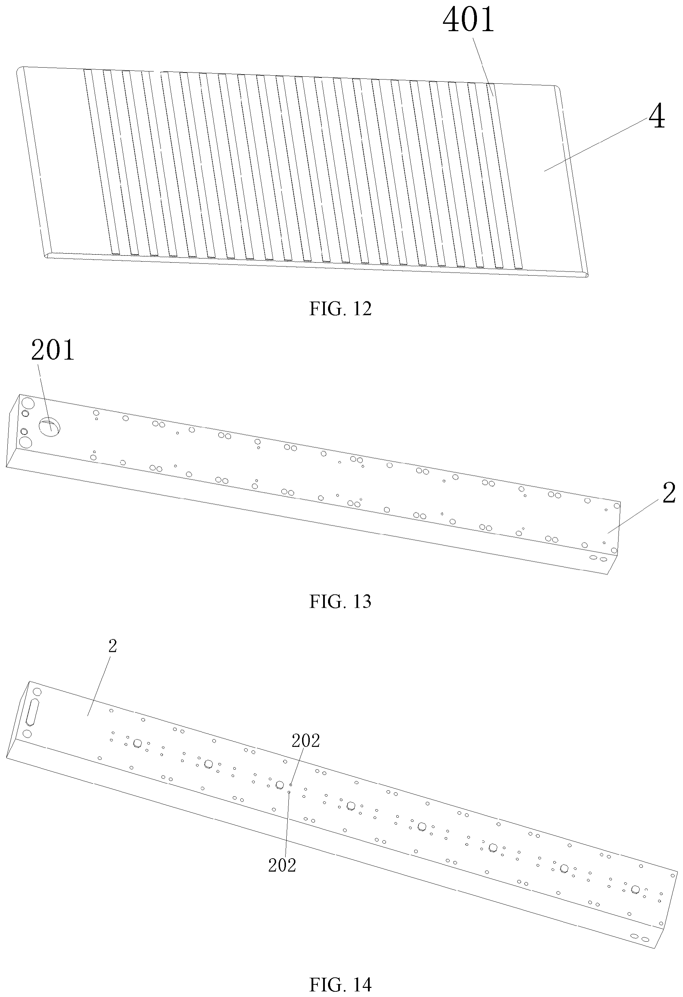

Further, the multi-waterway macro-channel mechanism 1 in the device provided by the present disclosure also includes a top plate 4 and forty-eight partition plates 104. The forty-eight partition plates 104 are vertically mounted on the base plate 105 to separate the thirty-two accommodating cavities 101, and the top plate 4 is laid flat on the partition plates 104 and disposed on a side of the accommodating cavities 101 away from the base plate 105. As shown in FIG. 10, each multi-waterway macro-channel module is installed with six partition plates 104, four of which surround a rectangle on the outside, and the other two partition plates104 cross to divide the multi-waterway macro-channel mechanism 1 into four regions, each corresponding to one accommodating cavity 101. The upper part of the accommodating cavity 101 is surrounded by the partition plates 104 and the top plate 4 to increase the range of air flow to achieve a better heat dissipation effect. Furthermore, as shown in FIG. 12, twenty-two raised strips 401 are arranged side by side on the top plate 4, and disposed on the plate surface of the top plate 4 away from the base plate 105. When the chip 6 is placed on the raised strips 401, the space beneath the chip 6 allows air to flow through, improving the heat dissipation effect for the chip 6.

Referring to FIGS. 13 and 14, the present disclosure provides a specific implementation of a water supply mechanism. The water supply mechanism 2 is provided with a first housing. The first housing has two parallel side walls. The two side walls are respectively provided with a water supply port 201 and outflow ports 202 with the same number as the first water inlets 102. The outflow ports 202 are in communication with the first water inlets 102 on the base plate 105, such that water flows into the water supply mechanism 2 from the water supply port 201 and then flows into the multi-waterway macro-channel modules. The centralized water supply to all multi-waterway macro-channel modules through the water supply mechanism 2 can ensure uniform water supply in each multi-waterway macro-channel module, thereby realizing uniform heat dissipation.

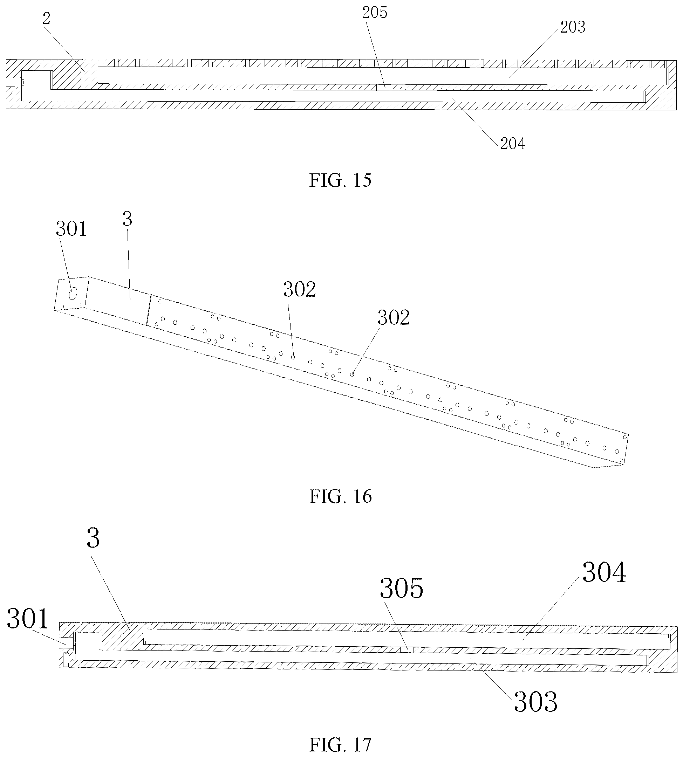

Further, referring to FIG. 15, a first water storage cavity 204 and a second water storage cavity 203 are arranged side by side in the first housing, and a connecting port 205 is provided between the two water storage cavities. The water supply port 201 is in communication with the first water storage cavity 204, and the second water storage cavity 203 is in communication with the sixteen outflow ports 202. In the water supply mechanism 2, the water flow enters from the water supply port 201, passes through the first water storage cavity 204, enters the second water storage cavity 203 through the connecting port 205, and the water in the second water storage cavity 203 flows out through the outflow port 202. In this process, through the cooperation of the first water storage cavity 204, the connecting port 205, and the second water storage cavity 203, the direction of the water flow can be made consistent with the outflow port, and through the energy storage effect of the second water storage cavity 203, the water flow from the plurality of outflow ports 202 can be made to flow at the same speed, so as to ensure that the water flow is consistent in the thirty-two multi-waterway macro-channel modules, thereby achieving consistent heat dissipation performance.

The present disclosure provides a specific implementation for the water outlet mechanism 3. Referring to FIG. 16, the water outlet mechanism 3 is provided with a second housing. The second housing has two side walls that are perpendicular to each other. The two side walls are respectively provided with a second water outlet 301 and second water inlets 302, the number of the second water inlets 302 is the same as that of the first water outlets 103. The second water inlets 302 of the water outlet mechanism are in communication with the first water outlets 103 of the multi-waterway macro-channel modules, and the second water outlet 301 discharge the water in the water outlet mechanism 3. The number of the water outlet mechanisms 3 is one pair, and the pair of water outlet mechanisms 3 are symmetrically distributed on both sides of the water supply mechanism 2.

Further, referring to FIG. 17, a third water storage cavity 303 and a fourth water storage cavity 304 are arranged side by side in the second housing, and a connecting port 305 is provided between the two water storage cavities. The third water storage chamber 303 is in communication with the second water inlet 302, and the fourth water storage cavity 304 is in communication with the second water outlet 301. The water flow enters the third water storage cavity 303 from the second water inlet 302 and then flows out of the second water outlet 301 in the fourth water storage cavity 304 through the connecting port 305, the process of which ensures that the water flow entering from each of the second water inlet 302 is subjected to the same water pressure, and, thus, ensures that the water flow through each of the second water inlet 302 is uniform. This is an active cooperation of the water supply mechanism 2, which results in better uniform heat dissipation.

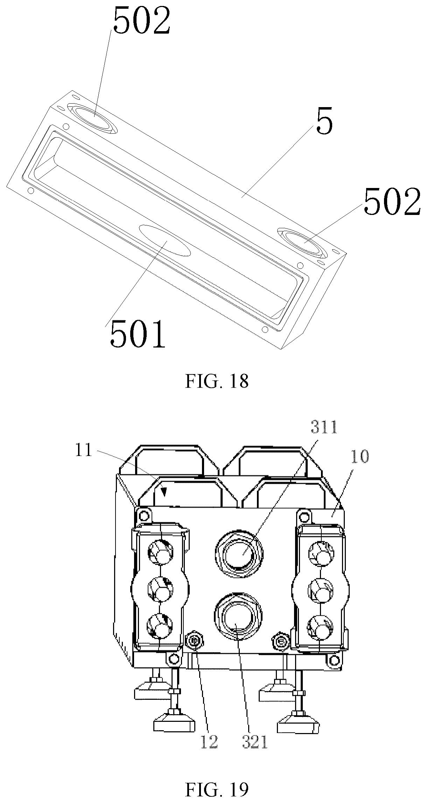

Referring to FIG. 18, the centralized uniform heat dissipation device for high-power multi-module chips provided by the present disclosure also includes a water outlet connection block 5. A fifth water storage cavity is provided in the water outlet connection block 5, a drain port 501 and interface ports 502 with the same number of water outlet mechanisms 3 are provided on the water outlet connection block 5. The interface port 502 is in communication with the second water outlet 301 and the fifth water storage cavity, and the drain port 501 is used to discharge water from the water outlet connection block. The water outlet connection block 5 converges the water flow from the left and right water outlet mechanisms 3 and then centralizes the discharge, which can make the structure reasonably compact.

In summary, the device provided by the present disclosure is arranged with a plurality of multi-waterway macro-channel mechanisms 1 arranged side by side, which increases the heat dissipation area and occupies a small volume. Each multi-waterway macro-channel mechanism 1 is provided with four multi-waterway macro-channel modules, such that the water flow is further divided into four parts. The smaller the water flow passing through the accommodating cavity 101, the faster the flow rate, thereby achieving a good heat dissipation effect. In addition, the water supply mechanism 2 and the water outlet mechanism 3 realize uniform water supply and water discharge respectively, ensuring consistent heat dissipation effect of each multi-waterway macro-channel module, and thus achieving the uniform heat dissipation effect.

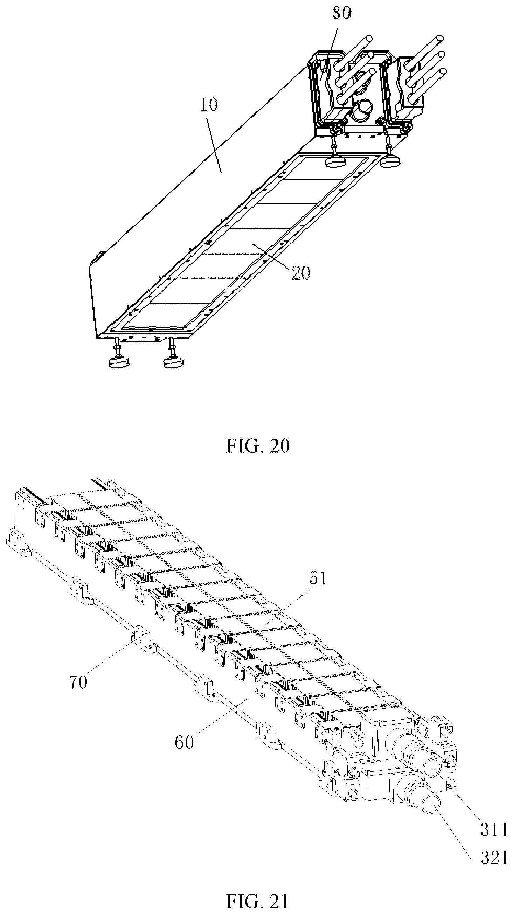

As shown in FIGS. 19 and 20, the present disclosure provides a laser heating device. The laser heating device includes a housing 10, a laser assembly, and a heat dissipation unit. The housing 10 is provided with an accommodating cavity 11 and an opening and a gas-filling port 12 respectively communicating with the accommodating cavity 11. The laser assembly is arranged in the accommodating cavity 11. The laser assembly includes an irradiation element arranged corresponding to the opening, enabling the irradiation element to emit light through the opening. The heat dissipation unit is arranged in the accommodating cavity 11 for dissipating heat from the irradiation element. The gas-filling port 12 is used to be connected to a gas-filling device.

By applying the technical solution of the present disclosure, the device is provided with a gas-filling assembly. During operation, the gas-filling assembly can inflate the interior of the accommodating cavity 11, so as to reduce the probability of external gases entering the accommodating cavity 11 and minimize the possibility of external gases polluting the environment within the accommodating cavity 11. Consequently, the laser assembly is protected, enabling the laser assembly to operate in a relatively safe environment, thereby facilitating the stable operation of the laser assembly.

In the embodiments of the present disclosure, the gas-filling assembly supplies inert gas into the accommodating cavity 11, and two gas-filling ports 12. This configuration can maximize the gas-filling capacity of the gas-filling assembly. Meanwhile, in the atoms of inert gases, electrons are arranged in each electron shell to exactly reach a stable number. Therefore, the atoms are not prone to losing or gaining electrons and thus hardly undergo chemical reactions with other substances, which makes inert gases extremely chemically inert. This can reduce the probability of the laser assembly coming into contact with external gases, thereby avoiding the risk of oxidation of the laser assembly and further ensuring the normal operation of the device.

Meanwhile, the opening is provided at the bottom of the housing 10, and the irradiation direction of the irradiation member is arranged from the top of the housing 10 toward the bottom of the housing, such that the objects at the bottom of the device can be heated by irradiation. Optionally, the opening may also be provided at other positions of the housing 10, with the specific arrangement determined according to the operating environment of the device.

In other embodiments of the present disclosure, the number of gas-filling ports 12 may also be three, four, five, and so on, with the specific arrangement determined according to the operating environment of the device. In this way, the application range of the device can be expanded to meet the usage requirements of users.

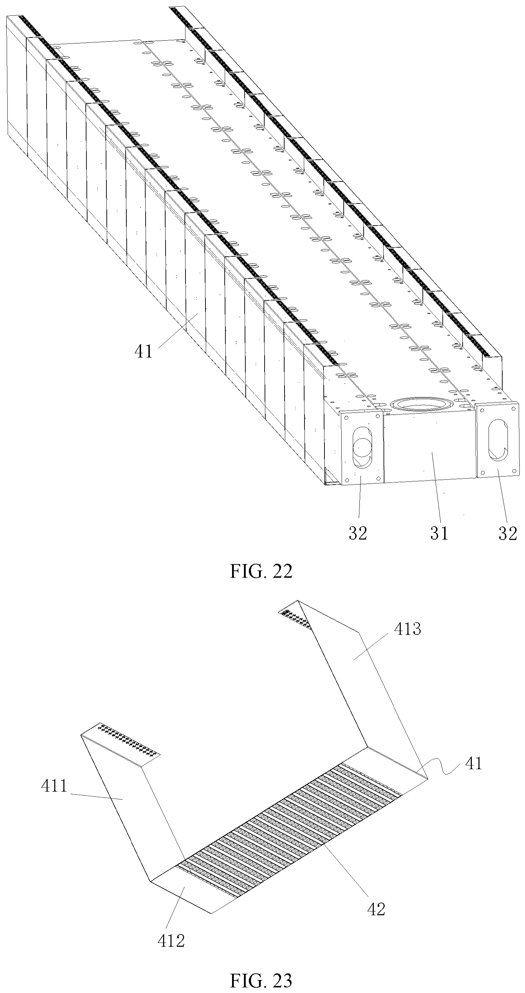

As shown in FIG. 22, the laser heating device further includes a sealing member 20 arranged at the opening to seal the accommodating cavity 11, and the sealing member 20 is configured to transmit light emitted by the irradiation member. By providing the above-described structure, when the gas-filling assembly is inflated into the accommodating cavity 11, the pressure in the accommodating cavity 11 can be made greater than the pressure of the outside gas, so as to reduce the risk of the outside gas flowing into the accommodating cavity 11, and further protect the laser unit to improve the protective effect of the gas-filling assembly.

In the embodiments of the present disclosure, the sealing member 20 is specifically configured as a transparent window piece, which not only meets the sealing requirements of the device, but also allows the light from the irradiation member to pass through the window piece to irradiate and heat objects. Meanwhile, the number of sealing members 20 in the present disclosure is seven, and the seven sealing members 20 are spliced together to seal the opening. This design facilitates the replacement of the sealing members 20, improving the disassembly and assembly efficiency for personnel, thereby enhancing the maintenance efficiency of the device.

As shown in FIGS. 21 and 2, the heat dissipation unit includes an inlet pipe 31 and an outlet pipe 32. The second water outlet 321 of the inlet pipe 31 is in communication with a first water inlet 311 of the outlet pipe 32, enabling the heat dissipation medium to flow through the inlet pipe 31 and the outlet pipe 32. The inlet pipe 31 is used to dissipate heat from the irradiation member.

In the embodiments of the present disclosure, the outer wall of the outlet pipe 32 is affixed to the back of the irradiation member, and the laser heating device further includes a water pump. The water pump is connected in series between the inlet pipe 31 and the outlet pipe 32 to drive the heat dissipation medium to circulate in the inlet pipe 31 and the outlet pipe 32, and the water pump can recycle the heat dissipation medium to reduce the operating costs of the device.

The heat dissipation unit may also be configured for air cooling. The specific configuration shall be selected according to the operating environment of the equipment, as long as it can meet the heat dissipation requirements of the device.

Specifically, the extension direction of the inlet pipe 31, the extension direction of the outlet pipe 32, and the extension direction of the laser assembly are parallel to each other. Meanwhile, both the first water inlet 311 end of the inlet pipe 31 and the second water outlet 321 end of the outlet pipe 32 penetrate the housing 10. In the present disclosure, the extension direction of the inlet pipe 31 is the same as that of the accommodating cavity 11. This makes it possible to rationally utilize the internal space of the accommodating cavity 11, thereby reducing the installation space for the inlet pipe 31, the outlet pipe 32, and the laser assembly. As a result, the overall volume of the device is reduced, which is conducive to the miniaturization of the device.

Meanwhile, outlet pipes 32 are arranged on both sides of the inlet pipe 31, which can increase the outflow of the heat dissipation medium, thereby improving the circulation efficiency of the heat dissipation medium and enhancing the heat dissipation effect of the heat dissipation assembly. The heat dissipation medium includes water, ethylene glycol, and additives. Water and ethylene glycol are mainly used to reduce the temperature of the laser assembly, while additives can inhibit corrosion and oxidation in the pipes and prevent the inner walls of the pipes from being damaged after long-term use of the heat dissipation medium.

As shown in FIG. 23, the laser assembly further includes a circuit board 41 electrically connected to the irradiation member. The circuit board 41 is provided with a first plate body 411, a second plate body 412, and a third plate body 413 connected in sequence. The second plate member 412 has a first side facing away from the opening and a second side facing towards the opening. The first plate member 411 and the third plate member 413 are disposed on the first side, the irradiation member is arranged on the second side, and the heat dissipation unit is disposed between the first plate body 411 and the third plate body 413. In the present disclosure, the irradiation member includes a plurality of chip light beads 42, the chip light beads 42 are encapsulated in 22 rows and 16 columns of 352 chips on the second plate body 412. Meanwhile, the maximum power of a single chip can be up to 8w, enabling a single module to deliver a laser power output of 2816w. The chip light beads 42 include a laser chip, a 5050 heat sink, and a protective cover. The laser chip is encapsulated on the 5050 heat sink, with the protective cover protecting the laser chip. Meanwhile, the laser chip in the present disclosure is a vertical-cavity surface-emitting laser chip, and the laser of the vertical-cavity surface-emitting laser has the advantages of a narrow line width (0.35 nm) and a minimal wavelength temperature drift (0.06 nm/°C). In addition, the lasers of the vertical-cavity surface-emitting lasers also have a small threshold current (1 mA), which provides higher efficiency than the lasers of the distributed-feedback semiconductor laser and the lasers of the semiconductor laser for the same output power, and do not generate chirps as easily as the lasers of the distributed-feedback semiconductor laser, and thus even data at a speed of 10 Gbps can be directly modulated by the laser of the vertical-cavity surface-emitting laser, even though the data can be directly modulated by the laser of the vertical-cavity surface-emitting laser, the collimated vertical cavity surface emitting laser is easier to fabricate and adjust than other lasers, which reduces the production cost of the device, and the excitation wavelength of the vertical cavity surface emitting laser is very stable, which ensures the stability of the device during operation.

Optionally, the laser chip may also be selected with other power specifications, such as 10W or 12W, as long as it can meet the operating requirements of the device.

Further, the laser heating device further includes a control unit. The control unit is electrically connected to the circuit board 41 to control the operating state of the laser assembly. This configuration facilitates users to control the device through the control unit, thereby ensuring the safety of the device during operation.

Specifically, the control unit includes a plurality of control boards 51, the laser assembly includes a plurality of circuit boards 41. The control boards 51 are in one-to-one correspondence with the circuit boards 41. This configuration allows each control board 51 to independently manage one circuit board 41, preventing mutual interference between electronic components and ensuring operational stability. In the present disclosure, the number of circuit boards 41 is set to sixteen, enabling a total power output of 45 kW to meet ultra-high-power heating requirements.

In the present disclosure, the control unit further includes a drive board 53. The drive board 53 is electrically connected to both the circuit board and the control board. Eight conductive columns 52 are arranged between the control board 51 and the driver board 53. This configuration can increase the current flow, thereby facilitating power supply from the power supply device to the circuit board 41.

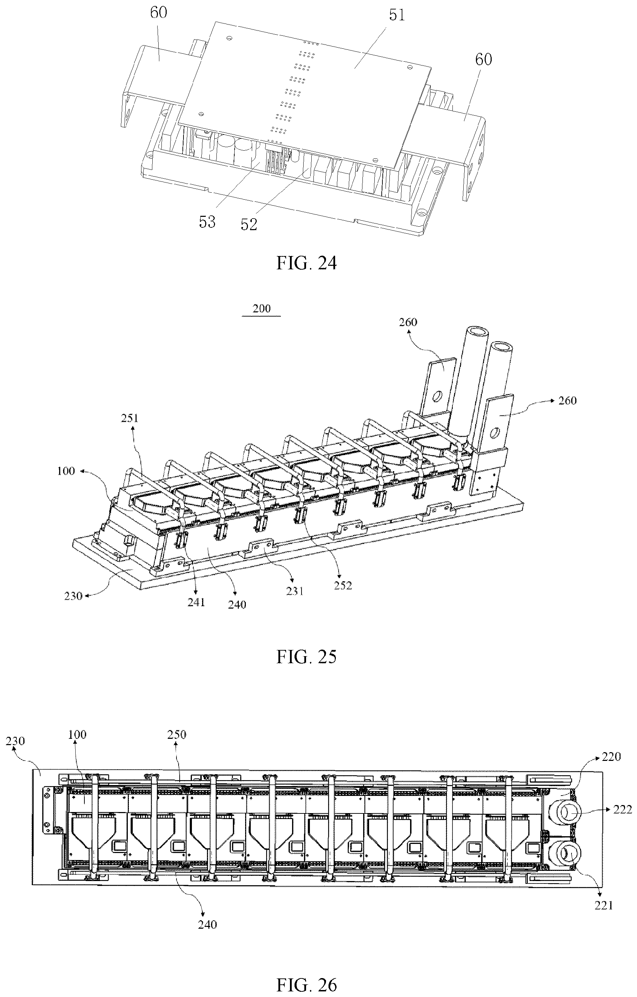

As shown in FIG. 24, the laser heating device further includes an adapter assembly, the adapter assembly is arranged in the accommodating cavity 11, one end of the adapter assembly is electrically connected to the power supply, and the other end of the adapter assembly is electrically connected to both the control assembly and the laser unit. The adapter assembly is used to supply power to the control assembly and the laser unit. By implementing the structure, the external voltage can be converted into a voltage suitable for the operation of the device, thereby protecting the internal components from damage, ensuring the device functions properly and extending the service life of the device.

As shown in FIG. 20, the adapter assembly includes a conductive member 60, an insulating member 70, and an adapter member 80. The conductive members 60 are provided on both sides of the laser assembly. The insulating member 70 is disposed between the conductive member 60 and the housing 10, one end of the adapter member 80 is electrically connected to the conductive member 60, and the other end of the adapter member 80 is electrically connected to the external circuit. In the embodiments of the present disclosure, the conductive member 60 and the adapter member 80 are both configured as a copper block. Copper has low resistivity, good ductility (with electrical copper exhibiting ductility exceeding 30%), high strength, fatigue resistance, high current-carrying capacity, and low voltage drop (due to the low resistivity of the copper cable, under the condition of the same cross-section flowing through the same current, the copper cable has a low voltage drop to ensure a higher quality of the voltage, or, under permissible voltage drop conditions, copper cables can transmit electricity over greater distances, i.e., the power supply covers a large area). This not only meets the conductivity requirements of the device, thereby reducing the production costs of the device while enhancing conductivity performance, but also allows the insulating element 70 to prevent current from overflowing, thus ensuring the operational safety of the device.

Optionally, the material of the conductive member 60 may also be aluminum, and the specific configuration method should be selected according to the operating environment of the device.

Meanwhile, the laser heating device also includes a heavy-duty connector. The heavy-duty connector is connected to three long cables of the external power supply, and is connected to the adapter member 80 through short cables, and the three adapter members 80 are mounted on the conductive member 60, enabling the introduction of external current into the product interior. The heavy-duty connector has the following advantages: 1. Pre-assembly capability: Pre-installing complex circuitry significantly enhances device installation efficiency and reduces wiring error rates; 2. Highly integrated connections with versatile configurations maximize efficient use of device space; 3. Enable convenient and efficient modularization of functional modules, facilitating safe and easy transportation, installation, maintenance, and repair; 4. Heavy-duty connectors deliver unmatched advantages for equipment connection systems in harsh environments through high protection ratings (IP65, IP67), thereby enhancing the safety performance of the device.

Specifically, the conductive member 60 extends along the length direction of the housing 10, with different electrodes on each side of the laser assembly. The conductive member 60 is in one-to-one correspondence with the adapter member 80. By arranging the above structure, not only can the internal space of the holding cavity 11 be further utilized, but also the introduction and discharge of external positive and negative power sources can be realized to meet the power supply requirements of the device.

In the present disclosure, the top of the housing 10 is provided with four handles, which are arranged at intervals along the circumferential direction of the housing 10 and distributed around the housing 10, thereby facilitating the user handling of the device, and are conducive to improving the handling efficiency of the device. The bottom of the housing 10 is provided with four foot pads, which can support the device to prevent the risk of the device from tipping over during use. Optionally, the foot pads can also be configured as rollers, so as to realize the movement of the device, thereby reducing the friction force when the device moves against the ground, further facilitating the transportation of the device and lowering the handling intensity for the user.

In addition, one side of the housing 10 is provided with a control panel. The control panel is provided with a plurality of communication interfaces and a signal light. This allows the users to connect to an external control host through the communication interfaces for functional control of the product. The signal light can promptly display the operational status of the product, thereby minimizing the malfunctioning situation of the device.

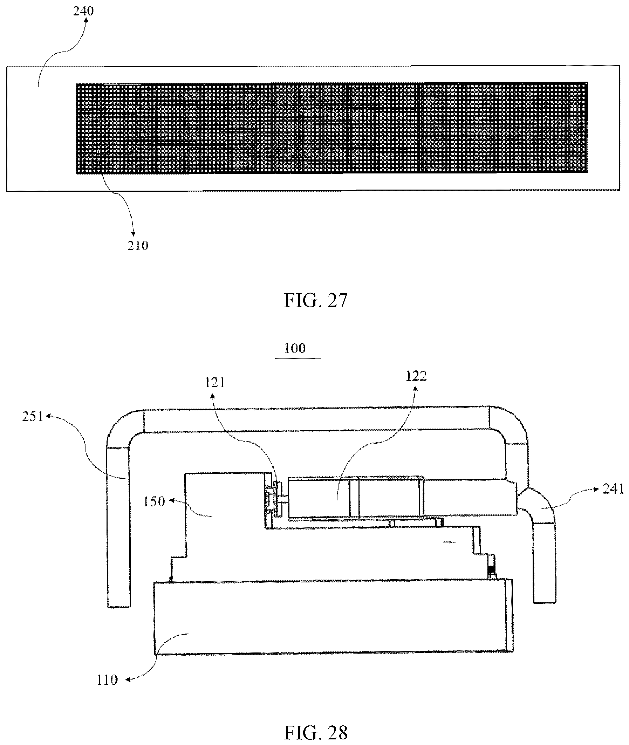

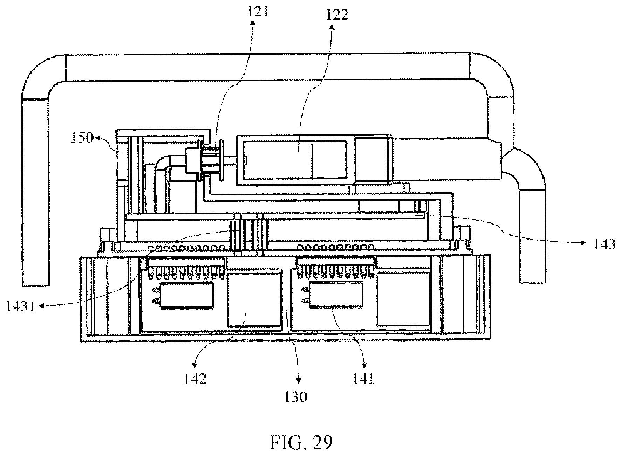

Referring to FIGS. 28 and 29, in an aspect of the embodiments of the present disclosure, a circuit drive box 100 is provided, which includes a base 110. A component device is arranged within the base 110, and a plug-in part electrically connected to an external power supply is provided on the outer wall of the base 110, with the component device being electrically connected to the plug-in part. The base is filled with the thermal grease 130, which encapsulates the component device to conduct the heat from the component device to the base 110.

Specifically, the present disclosure provides a circuit drive box 100. The circuit drive box 100 is provided with a base 110. A holding cavity is arranged in the base 110, and a component device is arranged in the holding cavity. The component device is capable of supporting a high-power consumption application. The outer wall of the base 110 is provided with a plug-in part electrically connected to an external power supply. The component device is electrically connected to the plug-in part, and the plug-in part is used to realize the circuit conduction. The holding cavity within the base 110 is filled with a thermal grease 130. As a highly thermally conductive and insulating organosilicon material, the thermal grease 130 can provide a good thermal conductivity effect on the component device and encapsulates the component device. When the component device is in a high-power application scenario, the component device generates a large amount of heat. At this time, the thermal grease 130 can efficiently conduct the heat away from the base 110 to achieve good heat dissipation within the circuit drive box 100.

The circuit drive box 100 provided by the embodiments of the present disclosure includes a base 110. A component device is provided within the base 110, a plug-in part electrically connected to an external power supply is provided on the outer wall of the base 110, and the component device is electrically connected to the plug-in part to enable the circuit of the circuit drive box 100 to be electrically connected to the external power supply. The base 110 is filled with the thermal grease 130, which encapsulates the component device to conduct heat from the component device to the base 110. The arrangement of the thermal grease 130 enables efficient heat dissipation for the high-power component device. The circuit drive box 100 obtained by the above design not only ensures reliable electrical connectivity with the external power source but also enhances thermal performance, operational safety, and reliability of the circuit drive box 100, thereby extending the service life of the circuit drive box 100.

In some embodiments of the present disclosure, as shown in FIG. 29, the component device includes a drive element 141 and a first circuit board 142 electrically connected to the drive element 141, and the first circuit board 142 is disposed in the base 110.

Further, as shown in FIG. 29, the circuit drive box 100 further includes a cover plate 150 covering the base 110, and the component device further includes a second circuit board 143 electrically connected to the drive element 141. The second circuit board 143 is disposed within the cover plate 150 and is electrically connected to the drive element 141 through the conductive copper pillars 1431.

Specifically, the component device includes a drive element 141 and a first circuit board 142 electrically connected to the drive element 141. The drive element 141 and the first circuit board 142 are provided within the base 110. The circuit drive box 100 further includes a cover plate 150, which is mounted over the base 110 and in communication with the holding cavity within the base 110. A second circuit board 143 is disposed within the cover plate 150, and is electrically connected to the drive element 141 via the conductive copper pillars 1431. The plug-in part is electrically connected to the second circuit board 143 for good circuit conduction.

Through this configuration, while ensuring the circuit conduction, the components within the component devices of the circuit drive box 100 are stacked in sequence to reduce the volume of the circuit drive box 100, resulting in a more compact structure.

Exemplarily, as shown in FIGS. 28 and 29, the plug-in part includes a plug 122 and a socket 121 for plug-in connection. One side of the socket 121 is fixedly connected to the cover plate 150 and extends into the cover plate 150 to be electrically connected to the second circuit board 143. The end of the plug 122 facing away from the socket 121 is electrically connected to an external power source to realize the circuit conduction.

Specifically, the plug-in part includes a plug 122 and a socket 121 for plug-in connection. The distal end of the socket 121 is fixedly connected to and extends into the cover plate 150 to be electrically connected to the second circuit board 143 within the cover plate 150 to realize the conduction of the plug-in part with the component device. The end of the plug 122 facing away from the socket 121 is electrically connected to an external power source, such that when the plug 122 is plugged into the socket 121, the circuit is turned on; when the plug 122 is disconnected from the socket 121, the circuit is turned off. The plug-in connection of the plug-in part makes the operation of turning the circuit on or off more convenient. Moreover, the plug-in part is attached and fixed to the cover plate 150, which can make the structure of the circuit drive box 100 more compact and small.

In another aspect of the embodiments of the present disclosure, a laser module 200 is provided. The laser module 200 includes the above-described circuit drive boxes 100 and a plurality of chip lamp beads 210. The plurality of circuit drive boxes 100 are arranged side by side on the plate surface of a water-cooled plate 220 and are electrically connected to an external power supply. The plurality of chip lamp beads 210 are arranged side by side on the side of the water-cooled plate 220 facing away from the circuit drive boxes 100 and are in one-to-one correspondence with the positions of the plurality of circuit drive boxes 100 and are electrically connected to the plurality of circuit drive boxes.

Specifically, shown in FIGS. 25 and 27, the present disclosure provides a laser module 200. The laser module 200 includes a plurality of circuit drive boxes 100 and a plurality of chip lamp beads 210. The number of the circuit drive boxes 100 is the same as the number of the chip lamp beads 210. In a preferred embodiment of the present disclosure, as shown in FIG. 25, there are eight circuit drive boxes 100 and eight chip lamp beads 210. The eight circuit drive boxes 100 are arranged side by side on the plate surface of the water-cooled plate 220, the eight chip lamp beads 210 are arranged side by side on the plate surface of the water-cooled plate 220 away from the surface of the circuit drive box 100, and each of the circuit drive boxes 100 corresponds to one chip lamp bead 210. Each of the circuit drive boxes 100 and the corresponding chip lamp bead 210 are electrically connected through the circular holes opened on the water-cooled plate 220. The circuit drive box 100 is electrically connected to an external power supply, and the chip lamp beads 210 can be lit up through the circuit conduction of the external power supply. The water-cooled plate 220 can provide a good heat dissipation environment for the circuit drive boxes 100 and the chip lamp beads 210. In a high-power working environment, the heat from the electrical structure inside the circuit drive box 100 can be conducted to the base 110 through the thermal grease 130, and then the base 110 transfers the heat to the water-cooled plate 220. The specific structure and beneficial effects of the circuit drive box 100 are described in detail above and will not be repeated herein.

In the laser module 200 provided by the embodiments of the present disclosure, by arranging the plurality of circuit drive boxes 100 side by side on the plate surface of the water-cooled plate 220, the structure of the laser module 200 is made more compact. Meanwhile, the arrangement of the water-cooled plate 220 can also cool the circuit drive boxes 100, which improves the thermal conductivity, safety, and reliability of the laser module 200 in use, and extends the service life of the circuit drive boxes 100. The circuit drive boxes 100 are electrically connected to an external power supply and the chip lamp beads 210 respectively to achieve circuit conduction. The laser module 200 obtained through the above design not only achieves good circuit conduction with the external power supply and the chip lamp beads 210, but also has a more compact structure, thereby improving the thermal conductivity, safety, and reliability of the laser module 200 in use, and extending the service life of the laser module 200.

Exemplarily, as shown in FIG. 26, the water-cooled plate 220 is provided with an inlet pipe 221 and an outlet pipe 222 for connecting with the cooling water pipes, respectively.

Specifically, as shown in FIG. 26, the cooling water pipes are further provided with an inlet pipe 221 and an outlet pipe 222. The inlet pipe 221 and the outlet pipe 222 are respectively connected to the cooling water pipes, such that cooling water in the cooling water pipes flows into the inlet pipe 221, and then cooling water that absorbs excess heat continuously flows out of the outlet pipe 222. By arranging the inlet pipe 221 and the outlet pipe 222, the cooling water in the water-cooled plate 220 can be constantly renewed, which ensures a good cooling effect of the water-cooled plate 220, further improves the heat dissipation efficiency of the laser module 200, and prolongs the service life of the laser module 200.

In some embodiments of the present disclosure, the laser module 200 further includes a mounting base 230. The surface of the water-cooled plate 220 facing away from the circuit drive box 100 is fixedly connected to the mounting base 230. The mounting base 230 is in a hollow ring structure, and the hollow portion is used for mounting a plurality of chip lamp beads 210 side by side.

Specifically, the laser module 200 further includes a mounting base 230. The mounting base 230 is a rectangular hollow annular structure. The surface of the water-cooled plate 220 facing away from the circuit drive box 100 is fixedly connected to the mounting base 230. The hollow portion is used for mounting a plurality of chip lamp beads 210 arranged side by side to ensure that the light can be emitted without obstruction when the chip lamp beads 210 are lit. The arrangement of the mounting base 230 can play a fixing role in the installation of various components and improve the connection stability.

In some embodiments of the present disclosure, the laser module 200 further includes a positive copper block 240 and a negative copper block 250. The positive copper block 240 is attached to one side of the circuit drive box 100 along the arrangement direction of the plurality of circuit drive boxes 100, and the negative copper block 250 is attached to one side of the circuit drive box 100 facing away from the positive copper block 240 along the arrangement direction of the plurality of circuit drive boxes 100. The sides of the positive copper block 240 and the negative copper block 250 close to the mounting base 230 are respectively fixedly connected to the mounting base 230 through the insulating bases 231.

Specifically, the laser module 200 further includes a positive copper block 240 and a negative copper block 250. The positive copper block 240 and the negative copper block 250 are respectively attached to two opposite sides of the plurality of circuit drive boxes 100, and are attached along the arrangement direction of the plurality of circuit drive boxes 100. The insulating base 231 is provided on the sides of the positive copper block 240 and the negative copper block 250 close to the mounting base 230. The insulating base 231 is used to fix the positive copper block 240 and the negative copper block 250 to the mounting base 230, respectively.

Further, the circuit drive box 100 includes a plug-in part. The plug-in part includes a socket 121 and a plug 122. The plug 122 is provided with a positive cable 241 and a negative cable 251. The positive cable 241 is connected to the positive copper block 240 through a cable locking block 252, and the negative cable 251 is connected to the negative copper block 250 through a cable locking block 252.

Specifically, the circuit drive box 100 includes a plug-in part. The plug-in part includes a socket 121 and a plug 122 for plug-in connection. One end of the plug 122 away from the socket 121 is provided with a positive cable 241 and a negative cable 251. The positive cable 241 and the negative cable 251 are electrically connected to the positive copper block 240 and the negative copper block 250, respectively, through the cable locking blocks 252. This configuration ensures both reliable electrical conduction for the laser module 200 and a compact structural design.

In the embodiments of the present disclosure, the positive copper block 240 and the negative copper block 250 are each fixedly connected to an external conductive block 260.

Specifically, the positive copper block 240 and the negative copper block 250 are each fixedly connected to an external conductive block 260. The external conductive block 260 can be respectively connected to the positive cable and the negative cable of the external power supply, and ultimately to the plug 122 of the plug-in portion of the circuit drive box 100. When the plug 122 of the plug-in portion is plugged into the socket 121, the circuit conducts, and the circuit drive box 100 drives the chip light bulb 210 to illuminate; when the plug 122 of the plug-in portion is disconnected from the socket 121, the circuit is disconnected, and the chip light bulb 210 turns out. The arrangement of the external conductive block 260 realizes good conduction between the laser module 200 and the external power supply, thereby improving the reliability of the laser module 200.

The technical features of the above-described embodiments may be arbitrarily combined, and all possible combinations of the technical features of each of the above-described embodiments have not been described to make the description simple, but as long as there is no contradiction in the combinations of these technical features, all of them should be considered to be within the scope of protection of the present specification.

The above-described embodiments represent only a few embodiments of the present disclosure, which are described in greater detail, but cannot be construed as a limitation of the scope of the present disclosure. It should be noted that, for those skilled in the art, without departing from the spirit of the present disclosure, if thousands of deformations and modifications can be made, these deformations and modifications are within the scope of protection of the present disclosure. Therefore, the scope of protection of the patent disclosure shall be subject to the attached claims.

## Claims

1. A high-power laser heating module, comprising:
a heat sink block, wherein a cooling water channel is arranged in the heat sink block, and a plurality of heat-conducting bosses are integrally formed on a top surface of the heat sink block;
a drive circuit board, arranged on a bottom surface of the heat sink block;
a flexible circuit board, attached to the heat sink block, wherein the flexible circuit board is provided with embedded slots for the heat-conducting bosses to pass through, and both sides of the flexible circuit board are provided with bent sections extending from the heat sink block, the bent sections being bent to the bottom surface of the heat sink block for electrical connection with the drive circuit board; and
a plurality of laser fixtures, arranged in an array on the heat-conducting bosses of the heat sink block and the flexible circuit board, wherein a laser chip is arranged in each of the plurality of laser fixtures, the laser chip of each of the plurality of laser fixtures is electrically connected to the flexible circuit board, and each of the heat-conducting bosses is embedded in one of the embedded slots of the flexible circuit board, so that the laser fixtures are thermally coupled to the heat sink block in a manner of bypassing the flexible circuit board.

2. The high-power laser heating module according to claim 1, wherein a side wall of each of the heat-conducting bosses abuts against a side wall of a corresponding embedded slot.

3. The high-power laser heating module according to claim 1, wherein each of the laser fixtures comprises a substrate for carrying the laser chip, the substrate being fixedly arranged on a heat-conducting boss.

4. The high-power laser heating module according to claim 3, wherein a transmission layer is arranged between the substrate and the laser chip, and a first contact pad for electrically connecting with the flexible circuit board is fixedly arranged on a bottom wall of the substrate.

5. The high-power laser heating module according to claim 4, wherein the heat-conducting boss is flush with or higher than a surface of the flexible circuit board.

6. The high-power laser heating module according to claim 1, wherein both ends of each of the bent sections are provided with positioning notches, and the heat sink block is fixedly provided with positioning ridges for snap-fitting with the positioning notches.

7. The high-power laser heating module according to claim 1, wherein the heat sink block is provided with an inlet pipe and an outlet pipe, the inlet pipe and outlet pipe being in communication with the cooling water channel, respectively.

8. The high-power laser heating module according to claim 7, wherein a heat dissipation structure of fin-pin is arranged in the cooling water channel.

9. An irradiation heating device for surface heating, comprising at least one group of module units, wherein each group of module units comprises a fixed beam and a plurality of high-power laser heating modules as defined in any one of claims 1 to 8, wherein the plurality of high-power laser heating modules are arranged along a length direction of the fixed beam, mounting blocks are fixedly arranged at the bottom of the heat sink block, the mounting blocks are arranged at both ends of the heat sink block along a length direction of the bent section, the mounting blocks being fixedly connected to the fixed beam.

10. The irradiation heating device according to claim 9, wherein each of the mounting blocks is provided with a locking groove, and a locking block for inserting into the locking groove is fixedly arranged on the fixed beam.

11. A centralized uniform heat dissipation device, comprising a water supply mechanism, a water outlet mechanism, and at least one multi-waterway macro-channel mechanism, wherein
each of the multi-waterway macro-channel mechanisms comprises a base plate and a plurality of multi-waterway macro-channel modules and has an accommodating cavity, wherein the base plate is provided with multiple pairs of first water inlets and first water outlets, and each pair of first water inlets and first water outlets is respectively in communication with the accommodating cavity, a water channel being arranged in the accommodating cavity to allow water to flow in from a first water inlet and then flow out from a first water outlet; and the plurality of multi-waterway macro-channel modules are symmetrically disposed on the base plate; and base plates of a plurality of multi-waterway macro-channel mechanisms face the same direction and are abutted side by side; and
the water supply mechanism and the water outlet mechanism are respectively in communication with first water inlets and first water outlets of the plurality of multi-waterway macro-channel modules, and are configured to supply water to the multi-waterway macro-channel modules and discharge water from the multi-waterway macro-channel modules.

12. The centralized uniform heat dissipation device according to claim 11, wherein the first water inlets and the first water outlets on the base plate are disposed on both sides of the accommodating cavity.

13. The centralized uniform heat dissipation device according to claim 11, wherein each of the multi-waterway macro-channel mechanisms further comprises a top plate and a plurality of partition plates, wherein the plurality of partition plates are vertically arranged on the base plate to separate a plurality of accommodating cavities, the top plate being laid flat on the partition plates and disposed on a side of the accommodating cavities away from the base plate.

14. The centralized uniform heat dissipation device according to claim 13, wherein a plurality of raised strips are arranged side by side on the top plate, the raised strips being disposed on a plate surface of the top plate away from the base plate.

15. The centralized uniform heat dissipation device according to claim 11, wherein the water supply mechanism is provided with a first housing having two parallel side walls, wherein the two side walls are respectively provided with a water supply port and outflow ports with the same number as the first water inlets, the outflow ports being in communication with the first water inlets on the base plate, so that water flows into the water supply mechanism from the water supply port and then flows into the multi-waterway macro-channel modules.

16. The centralized uniform heat dissipation device according to claim 15, wherein a first water storage cavity and a second water storage cavity are arranged side by side in the first housing, a connecting port is provided between the first water storage cavity and the second water storage cavity, the water supply port is in communication with the first water storage cavity, and the second water storage cavity is in communication with the plurality of outflow ports.

17. The centralized uniform heat dissipation device according to claim 11, wherein the water outlet mechanism is provided with a second housing having two side walls that are perpendicular to each other, wherein the two side walls are respectively provided with a second water outlet and second water inlets with the same number as the first water outlets, the second water inlet of the water outlet mechanism being in communication with the first water outlets of the multi-waterway macro-channel modules, and the second water outlets discharging water from the water outlet mechanism.

18. The centralized uniform heat dissipation device according to claim 17, wherein a third water storage cavity and a fourth water storage cavity are arranged side by side in the second housing, a connecting port is provided between the third water storage cavity and the fourth water storage cavity, the third water storage cavity is in communication with the second water inlets, and the fourth water storage cavity is in communication with the second water outlet.

19. The centralized uniform heat dissipation device according to claim 18, wherein the number of water outlet mechanisms is at least one pair, and each pair of water outlet mechanisms is symmetrically disposed on both sides of the water supply mechanism.

20. The centralized uniform heat dissipation device according to claim 19, further comprising a water outlet connection block, wherein a fifth water storage cavity is provided in the water outlet connection block, the water outlet connection block is provided with a drain port and interface ports with the same number as the water outlet mechanisms, the interface ports being in communication with the second water outlet and the fifth water storage cavity, and the drain port is configured to discharge water from the water outlet connection block.

21. A laser heating device, comprising:
a housing, provided with an accommodating cavity, and an opening and a gas-filling port respectively communicating with the accommodating cavity;
a laser assembly, arranged in the accommodating cavity, wherein the laser assembly comprises an irradiation member arranged corresponding to the opening, the irradiation member being capable of emitting light through the opening; and
a heat dissipation unit, arranged in the accommodating cavity for dissipating heat from the irradiation member;
wherein the gas-filling port is configured to be connected to a gas-filling device.

22. The laser heating device according to claim 21, further comprising a sealing member arranged at the opening to seal the accommodating cavity, the sealing member being configured to transmit light emitted by the irradiation member.

23. The laser heating device according to claim 21, wherein the heat dissipation unit comprises an inlet pipe and an outlet pipe, wherein a second water outlet of the inlet pipe is in communication with a first water inlet of the outlet pipe, and a heat dissipation medium is capable of flowing in the inlet pipe and the outlet pipe; and
the inlet pipe is configured to dissipate heat from the irradiation member.

24. The laser heating device according to claim 23, wherein an extension direction of the inlet pipe, an extension direction of the outlet pipe, and an extension direction of the laser assembly are parallel to each other; and/or,
both a first water inlet end of the inlet pipe and a second water outlet end of the outlet pipe penetrate the housing.

25. The laser heating device according to any one of claims 21 to 24, wherein the laser assembly further comprises a circuit board electrically connected to the irradiation member, the circuit board being provided with a first plate body, a second plate body, and a third plate body connected in sequence, wherein the second plate body has a first side facing away from the opening and a second side facing towards the opening, the first plate body and the third plate body are disposed on the first side, the irradiation member is arranged on the second side, and the heat dissipation unit is disposed between the first plate body and the third plate body.

26. The laser heating device according to claim 25, further comprising a control unit, wherein the control unit is electrically connected to the circuit board to control an operating state of the laser assembly.

27. The laser heating device according to claim 26, wherein the control unit comprises a plurality of control boards, the laser assembly comprises a plurality of circuit boards, wherein the control boards are in one-to-one correspondence with the circuit boards.

28. The laser heating device according to claim 27, further comprising an adapter assembly, wherein the adapter assembly is arranged in the accommodating cavity, one end of the adapter assembly is electrically connected to a power supply, and another end of the adapter assembly is electrically connected to the control boards and the circuit boards, respectively, the adapter assembly is configured to supply power to the control assembly and the circuit boards.

29. The laser heating device according to claim 28, wherein the adapter assembly comprises a conductive member, an insulating member and an adapter member, wherein the conductive member is provided on both sides of the laser assembly, the insulating member is disposed between the conductive member and the housing, one end of the adapter member is electrically connected to the conductive member, and another end of the adapter member is electrically connected with an external circuit.

30. The laser heating device according to claim 29, wherein the conductive member extends along a length direction of the housing, with different electrodes of the conductive member located on each side of the laser assembly, and the conductive member is in one-to-one correspondence with the adapter member.

31. A circuit drive box, comprising a base, wherein a component device is arranged in the base, an outer wall of the base is provided with a plug-in part electrically connected to an external power supply, the component device is electrically connected to the plug-in part; and the base is filled with a thermal grease, the thermal grease encapsulating the component device to conduct heat from the component device to the base.

32. The circuit drive box according to claim 31, wherein the component device comprises a drive element and a first circuit board electrically connected to the drive element, the first circuit board being disposed in the base.

33. The circuit drive box according to claim 32, further comprising a cover plate covering the base, wherein the cover plate is provided with a second circuit board, the second circuit board being electrically connected to the drive element through a conductive copper pillar.

34. The circuit driving box according to claim 33, wherein the plug-in part comprises a plug and a socket for plug-in connection, wherein one side of the socket facing away from the plug is fixedly connected to the cover plate and extends into the cover plate for electrical connection with the second circuit board, and one end of the plug facing away from the socket is electrically connected to an external power source to realize a circuit conduction.

35. A laser module, comprising the circuit drive box as defined in any one of claims 31 to 34 and a plurality of chip lamp beads, wherein a plurality of the circuit drive boxes arranged side by side on a plate surface of a water-cooled board and electrically connected to an external power supply, the plurality of the chip lamp beads arranged side by side on a side of the water-cooled board facing away from the circuit drive box, and in one-to-one correspondence with positions of the plurality of circuit drive boxes and electrically connected to the plurality of circuit drive boxes.

36. The laser module according to claim 35, wherein the water-cooled plate is provided with an inlet pipe and an outlet pipe, the inlet water pipe and outlet water pipe being in communication with a cooling water channel, respectively.

37. The laser module according to claim 35, further comprising a mounting base, wherein a side of the water-cooled plate facing away from the circuit drive box is fixedly connected to the mounting base, the mounting base is in a hollow annular structure, a hollow portion of the mounting base is configured to mount the plurality of chip lamp beads side by side.

38. The laser module according to claim 37, further comprising a positive electrode copper block and a negative electrode copper block, wherein the positive electrode copper block is attached to one side of the circuit drive box along an arrangement direction of the plurality of the circuit drive boxes, the negative electrode copper block is attached to one side of the circuit drive boxes facing away from the positive electrode copper block along the arrangement direction of the plurality of the circuit drive boxes, and sides of the positive copper block and the negative copper block close to the mounting base are respectively fixedly connected to the mounting base through insulating bases.

39. The laser module according to claim 38, wherein the circuit drive box comprises a plug-in part comprising a socket and a plug, wherein one end of the socket is connected to a cover plate of the circuit drive box, one end of the plug facing away from the socket is provided with a positive cable and a negative cable, the positive cable being connected to the positive electrode copper block through a cable locking block, the negative electrode cable being connected to the negative electrode copper block through a cable locking block.

40. The laser module according to claim 38, wherein the positive electrode copper block and the negative electrode copper block are each fixedly connected to an external conductive block.
